# EUROPEAN PATENT APPLICATION

(11) **EP 0 568 312 A2**
(43) Date of publication of application: **03.11.1993**
(21) Application number: 93303271.6
(22) Date of filing: 27.04.1993
(51) Int. Cl.: H01L 25/18

(54) **Semiconductor device with driver chip and methods of manufacture**

(30) Priority: 27.04.1992 JP 108159/92; 22.10.1992 JP 284666/92; 06.11.1992 JP 297193/92; 10.11.1992 JP 299650/92; 18.02.1993 JP 29493/93
(71) Applicant: SEIKO INSTRUMENTS INC., Tokyo 136 (JP)
(72) Inventor: Mandai, Masaaki, c/o Seiko Instruments Inc., Tokyo (JP); Takeuchi, Hitoshi, c/o Seiko Instruments Inc., Tokyo (JP); Saito, Yutaka, c/o Seiko Instruments Inc., Tokyo (JP); Yoshino, Tomoyuki, c/o Seiko Instruments Inc., Tokyo (JP)
(74) Representative: Sturt, Clifford Mark

(57) **Abstract**

The semiconductor device of the multiple chip mount type is constructed such that electrical and mechanical connections are carried out concurrently between the chips. Coupling chips 4 are utilized to couple a plurality of semiconductor chips 1 to each other, and couple the end semiconductor chips 1 to a driver substrate 3. The driver substrates 3 may have mounted thereon a semiconductor driving chip 2 for driving the semiconductor image sensor chips 1.

## Description

The present invention relates to a semiconductor device. In particular to a semiconductor device having a plurality of semiconductor chips such as a microcomputer chip, or a semiconductor image sensor chip and the like. In addition the present invention relates to a semiconductor image sensor device which is used for detecting not only visible light, infrared ray and ultraviolet ray, but also X-ray, radioactive ray and charged particles. The semiconductor image sensor device refers to various semiconductor integrated circuit devices including photodiodes, photodiode arrays, photosensors, microstrip sensors, two-face microstrip sensors, radioactive sensors, semiconductor photosensors and semiconductor imaging devices.

In the aforegoing specification, the term "detecting" means production of a signal upon receiving an optical ray or a radioactive ray. An element or a portion of the detection means is referred to as "photosensor" or "light receiving area". Further, the term "image sensor device" refers to a device composed of an arrangement of photosensors for producing two-dimensional image information according to detected signals from the photosensors. Such a type of device may be composed of a single photosensor chip for performing a certain function. However, the present invention particularly relates to a specific construction of the type composed of a plurality of sensor chips mechanically and electrically integrated with each other to function as the semiconductor image sensor device, as a whole. Hereinafter, such an integral construction will be referred to as "semiconductor image sensor device of the multiple chip mount type".

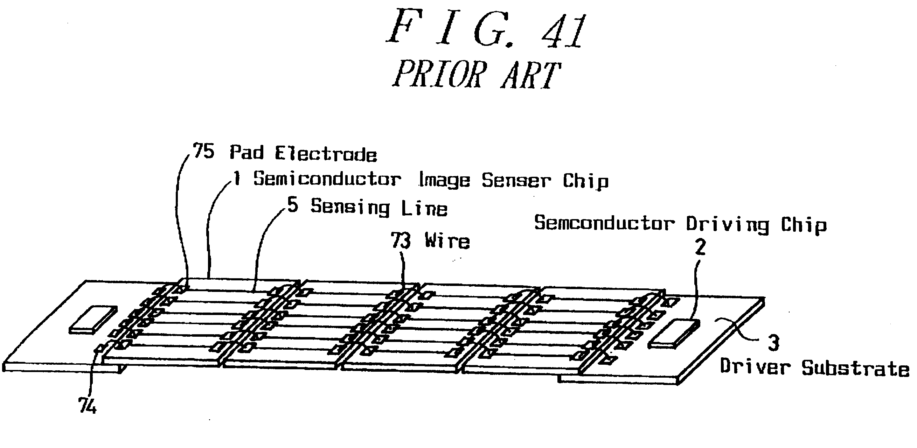

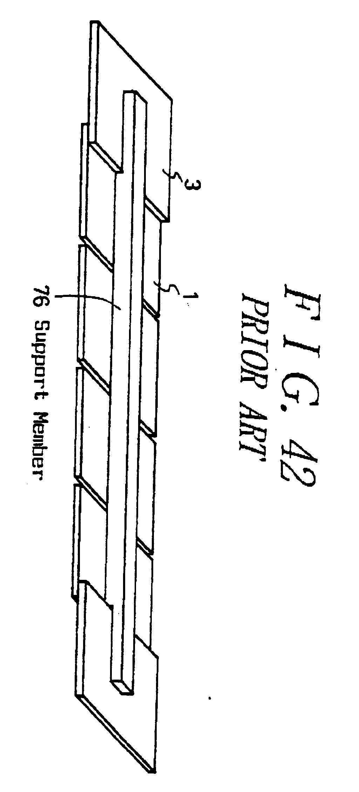

Figs. 41 and 42 show one type of conventional structure of a semiconductor image sensor device of the multiple chip mount type. In the prior art, as shown in Fig. 41, the sensor device comprises four semiconductor image sensor chips 1, and two driver substrates 3 for controlling the sensor chips 1 (to retrieve a signal). As shown in Fig. 42, these sensor chips 1 and driver substrates 3 are united with each other at the bottom by means of a single support member 76. In this conventional structure, electrical connection is provided by means of bonding wires 73 between the semiconductor image sensor chips 1 and driver substrates 3. In addition, each sensor chip 1 is formed with sensing lines 5 and corresponding pad electrodes 75 for wire bonding. Each driver substrate 3 is provided with a semiconductor driving chip 2 and pad electrodes 74 for wire bonding. Though not shown in the figures, the driving chip 2 and the driver substrate 3 are wire-bonded.

Though Fig. 41 is illustratively simplified for facilitating understanding, in practice, the semiconductor image sensor chips 1 have a size much greater than an ordinary semiconductor chip. For example, the sensor chips 1 each have a length of 50-70mm along the sensing line 5 and a width of 30 mm. Each sensor chip 1 contains about 600 sensing lines 5 (only 6 sensing lines 5 are illustrated in Fig. 41) aligned at a pitch of about 50 µm. Thus, the Fig. 41 device has an entire length of 0.3m and a width of 30mm.

As mentioned above, in the conventional semiconductor image sensor device of the multiple chip mount type, separate means are provided at the top and bottom sides for mechanically integrating the multiple chips and circuit substrates with each other, and for electrically connecting the chips to constitute a system. Such a construction raises the following various drawbacks. First, a mechanical support structure is necessarily required. Second, the mechanical support structure may affect the light receiving area so as to hinder the detection efficiency. Third, both mechanical coupling and electrical connections are needed which thereby prolongs the assembling time. Fourth, the electrical connections provided by the wire bonding, may not provide adequate conduction if the pad electrodes have an excessively narrow pitch. That is to say, during the wire bonding operation, an already coupled wire might be broken by a bonding tool. Fifth, even if the bonding operation is successfully completed, any inadvertent external force might be incidentally applied so that a wire is broken, or is contacted to an adjacent wire to cause a short circuit defect. Sixth, the mechanical rigidity solely depends on the support structure, thereby causing restriction of the shaping and positioning of the support member.

In addition, internal pattern arrangement is restricted in the semiconductor driving chip 2 because one must leave sufficient space for wire bonding. That is to say, the driving chip 2 is provided with input terminals corresponding to each of the sensing lines or strip lines which are arranged at a close pitch with each other. Therefore, the pitch of adjacent input terminals is also made close. In such a case, there may be insufficient space for forming an input signal processing circuit (input buffer) which is located in the vicinity of the input terminal. Consequently, it is practically difficult to reduce the pitch of the input terminal arrangement.

In order to solve the above noted problems of the prior art, an object of the present invention is to provide a semiconductor device of the multiple chip mount type, in which mechanical fixing and electrical connection is concurrently achieved yet ensuring sufficient mechanical rigidity, and in which stable electrical connection is ensured for the sensing lines which are disposed at a narrow pitch and the connection quality is stably maintained once the electrical connection work is completed. In addition, the present invention provides a semiconductor device having mechanical fixing and electrical connections which avoid adverse affects when there is a light receiving area.

According to the present invention there is provided a semiconductor device comprising:
a one or more of semiconductor chips;
a semiconductor driving chip for driving the or each semiconductor chip; characterised by combined mechanical and electrical means, said mechanical means for mechanically uniting either adjacent semiconductor chips with each other, or a semiconductor chip and a semiconductor driving chip; and
said electrical means for electrically connecting between the semiconductor chips and the semiconductor driving chip.

In the semiconductor device of the multiple chip mount type, a specific component, i.e., a coupling chip is utilized to couple an adjacent pair of semiconductor chips with each other, and to couple an adjacent pair of a semiconductor chip and a driver substrate. The specific component is composed of a solid piece such as a silicon chip or a glass chip which is formed thereon with lead lines and junction electrodes for electrical connection. The coupling chip is disposed such that one face is formed with the lead lines and junction electrodes opposed to the corresponding junction electrodes formed on the semiconductor chips. By such a mounting manner (hereinafter, called "facedown" mounting), the mechanical fixings and electrical connections are concurrently effected to ensure stable coupling without affecting the light receiving area. Additionally, after facedown coupling of adjacent elements, supplementary electrical connection may be added to the coupled portion. Preferably, a semiconductor driving chip may be also mounted on the driver substrate by facedown bonding. Further, if a certain mechanical strength is required in the semiconductor device, a supplementary reinforcement member is provided to obtain the desired strength. Moreover, if the semiconductor device is likely to generate a considerable amount of heat during operation, a radiator plate may be added to remove the harmful heat.

The thus constructed semiconductor device of the multiple chip mount type has the following features. First, a mechanical support structure can be eliminated in contrast to the prior art structure in which the mechanical support member may affect the light receiving area to hinder the detection efficiency. Second, the mechanical fixings and the electrical connections can be effected at once. Further the coupling is carried out in one step between adjacent semiconductor chips and between the semiconductor chip and the driver substrate, thereby reducing the working time. Third, the coupling chip has the lead lines formed on the chip face by a semiconductor process: hence the lead lines may not be broken or shorted during and after the coupling process. Further, a pattern density of the lead lines can be increased to enable narrow pitch connection, thereby increasing the density of sensing lines formed on the light receiving area of the semiconductor chips to improve the detection ability of the semiconductor device. Fourth, the semiconductor driving chip is mounted on the driver substrate by this facedown bonding, such that the input/output terminal pads can be arranged internally besides the peripheral area of the driving chip. Thus, the freedom to design the pad arrangement is significantly improved and so increases the yield rate by enlarging the pad pitch and pad size. This leads to an improved electric performance by optimising characteristics of circuit elements due to increased freedom of the internal element arrangement. Fifth, after completing the coupling work the lead lines and junction electrodes of the coupling chip and the corresponding junction electrodes of the sensor chip are concealed between the pairs of coupling chips and sensor chips. Consequently, the coupled portion is not exposed externally to thereby maintain the coupling quality and improve the reliability. Sixth, if further mechanical strength is required, a reinforcement member may be provided as a supplementary support structure, thereby improving the rigidity of the semiconductor device. The supplementary support reinforcement member may not have a large size, and one has freedom in its positioning. Therefore, the reinforcement members can be attached widthwise to opposite sides of the semiconductor chips so as to eliminate ill affects to the light receiving area. Seventh, a radiator plate can be attached to effectively prevent thermal damage of the semiconductor device during its operation. Eighth, in the sensing area, it is possible to reduce harmful things at sensing operation.

Embodiments of the present invention will now be described with reference to the accompanying drawings, of which:-
Figure 1 is a top plan view showing one embodiment of the inventive semiconductor image sensor device;
Figure 2 is an enlarged top plan view showing a junction portion of the Figure 1 embodiment;
Figure 3 is an enlarged side view showing the junction portion of the Figure 1 embodiment;
Figure 4 is a perspective rear view showing a coupling chip adopted in the Figure 1 embodiment;
Figure 5 is a perspective view illustrating an aligning operation of a monosilicon coupling chip in the Figure 1 embodiment;
Figure 6 is a perspective view illustrating another aligning operation of a driving chip;
Figure 7 is a top plan view illustrating the alignment of a glass coupling chip in the Figure 1 embodiment;
Figure 8 is an enlarged side view showing a coupling part using the glass coupling chip in Figure 7;
Figure 9 is a perspective view showing the glass coupling chip;
Figure 10 is a top plan view of a monosilicon driver substrate used in the Figure 1 embodiment;
Figure 11 is a perspective view showing the alignment of the semiconductor driving chip to a glass driver substrate in the Figure 1 embodiment;
Figure 12 is a perspective view showing a semiconductor image sensor chip mounted in the Figure 1 embodiment of the inventive semiconductor image sensor device;
Figure 13 is a perspective view of a semiconductor image sensor chip having auxiliary electrodes;
Figure 14 is a perspective view showing when a contact defect is repaired;
Figure 15 is a perspective view showing another way of repairing a contact defect;
Figure 16 is a perspective view showing checking of contacts in one embodiment of the inventive semiconductor image sensor device;
Figure 17 is a detailed plan view showing the driver substrate where the semiconductor driving chip is mounted as in the Figure 1 embodiment;
Figure 18 is an enlarged partial plan view showing the driver substrate before mounting the semiconductor driving chip in the Figure 17 embodiment;
Figure 19 is an enlarged partial plan view showing an active face of the semiconductor driving chip used in the Figure 17 embodiment;
Figure 20 is a top plan view showing the relative position between the semiconductor image sensor chips and driver substrates used in the Figure 1 embodiment;
Figure 21 is a top plan view showing a coupled state in which the semiconductor image sensor chips and driver substrates are connected by the coupling chips in the Figure 1 embodiment;
Figure 22 is a perspective view of a coupling chip, where an anisotropic electroconductive film is temporarily adhered to junction electrodes of the coupling chip;
Figure 23 is a perspective view in which an anisotropic electroconductive film is temporarily adhered to junction electrodes of adjacent semiconductor image sensor chips;
Figure 24 is a perspective view showing a thermal pressing step for coupling a pair of semiconductor image sensor chips by means of a coupling chip;
Figure 25 is a detailed plan view showing a glass coupling chip used in one embodiment of the inventive semiconductor image sensor device;
Figure 26 is a sectional diagram of the Figure 25 glass coupling chip, taken along the line A - A' of Figure 25;
Figure 27 is an illustrative diagram showing the principle of an anodic bonding method for bonding the glass coupling chip to the semiconductor image sensor chip;
Figure 28 is a sectional diagram where the semiconductor image sensor chips are coupled by using the glass coupling chip shown in Figures 25, 26;
Figure 29 is a detailed plan view showing one variation of the Figure 25 glass coupling chip;
Figure 30 is a sectional diagram of the Figure 29 glass coupling chip, taken along the line AA - AA';
Figure 31 is an enlarged sectional diagram showing a mount portion of the semiconductor driving chip on the driver substrate;
Figure 32 is a top plan view showing another embodiment of the inventive semiconductor image sensor device;
Figure 33 is a sectional view taken along the line ZA - ZA' of Figure 32;
Figure 34 is a enlarged perspective view showing a reinforcement side plate provided in the Figure 32 embodiment;
Figure 35 is a plan view showing a further embodiment of the inventive semiconductor image sensor device, having a radiator plate;
Figure 36 is an enlarged and detailed section showing an attached portion of the radiator plate in the Figure 35 embodiment;
Figure 37 is a plan view showing still further embodiment utilising an integrated active driver substrate which is integrated with a semiconductor driving circuit;
Figure 38 is a plan view showing a still further embodiment where an end coupling chip between the sensor chip and the driver substrate comprises an active coupling chip which is integrated with a driving circuit;
Figure 39 is a perspective view showing an even further embodiment of the inventive semiconductor image sensor device, where adjacent sensor chips are mechanically united with each other by using a coupling layer;
Figure 40 is a perspective view showing coupling of adjacent image sensor chips through coupling lines in the Figure 39 embodiment;
Figure 41 is a top perspective view showing a conventional semiconductor image sensor device; and
Figure 42 is a rear perspective view showing the same conventional semiconductor image sensor device.

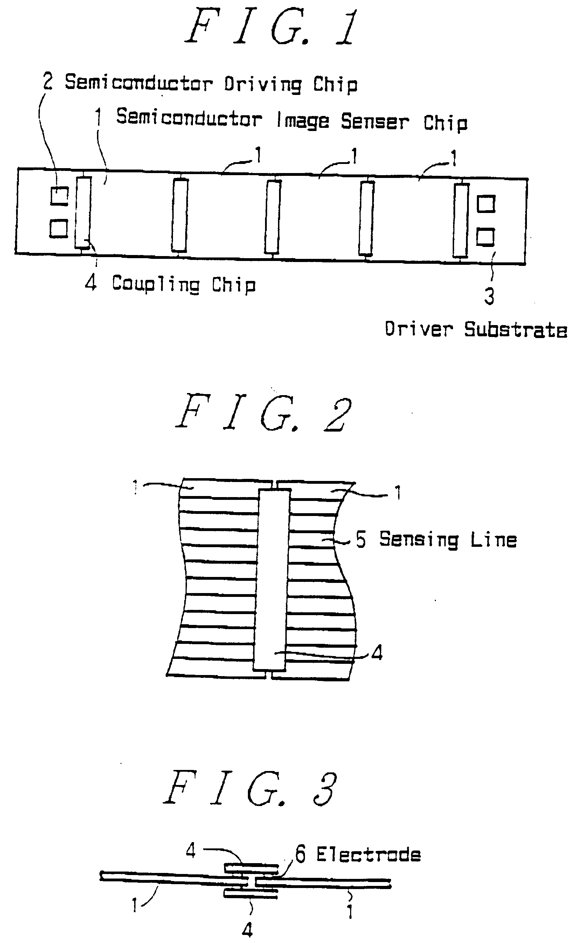

Fig. 1 is a top plan view showing one embodiment of the semiconductor image sensor device according to the present invention. Four pieces of semiconductor image sensor chips 1 are aligned in precise positional relation with each other. Adjacent pairs of sensor chips 1 are electrically and mechanically connected to one another by means of a coupling chip 4. A pair of driver substrates 3 are arranged adjacently to opposite end ones of the semiconductor image sensor chips 1, respectively. These driver substrate 3 mount thereon semiconductor driving chips 2 for carrying out control of the four sensor chips 1 and retrieval of information from the sensor chips 1. Each of the semiconductor image sensor chips 1 are the main components of the semiconductor image sensor device. Each are provided with junction electrodes (not shown in the figure) on its top and rear faces at opposite end portions thereof spaced apart leftward and rightward in the figure. In the intermediate remaining portion of each chip, there is provided a light receiving area or image sensing area on both of the top and rear faces.

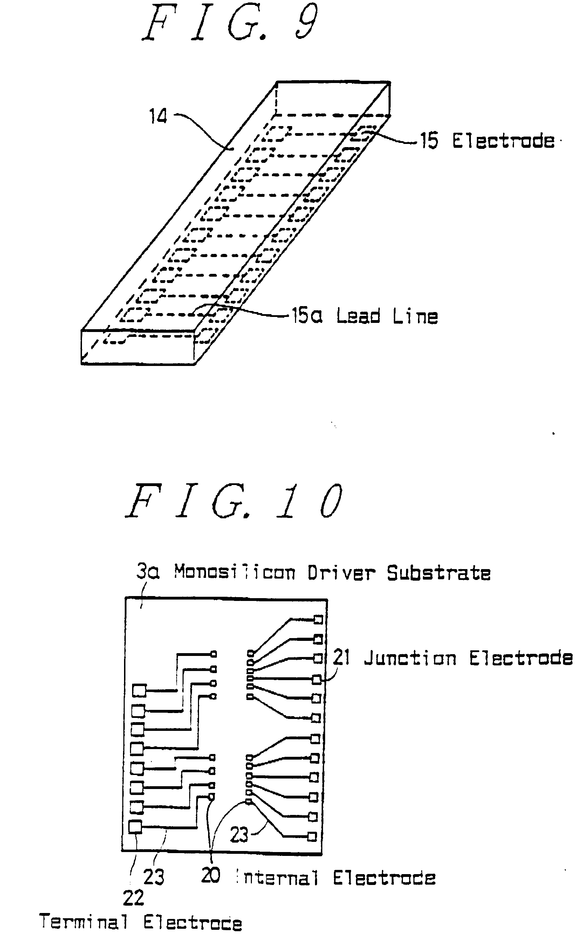

Fig. 10 is a detailed plan view showing a single crystal silicon (monosilicon) driver substrate which is used in the Fig. 1 embodiment. In this embodiment, the monosilicon driver substrate 3a is composed of a single crystal silicon plate having opposite circuit faces. The substrate 3a is provided on each face with internal electrodes 20 which are formed for electrical contact to the semiconductor driving chips 2 (not shown). Namely, the semiconductor driving chip 2 is mounted on the substrate in facedown manner such that electrodes of the driving chip 2 are opposed to the electrodes 20 of the substrate 3a. The semiconductor driving chip 2 has the function of driving the semiconductor image sensor chips 1, and to process signals from the sensor chips 1 for transmitting information from the sensor chips to a system (not shown) outside the semiconductor image sensor device. In order to effect transmission of the signal to the external system, the monosilicon driver substrate 3a is formed with terminal electrodes 22 for external connection. Further, the monosilicon driver substrate 3a is provided with junction electrodes 21 at an end portion of the top and rear faces, close to an adjacent semiconductor image sensor chip 1 for electrical connection thereto. Moreover, the monosilicon driver substrate 3a is composed of the same material, i.e., single crystal silicon, as those of the semiconductor image sensor chips 1, coupling chips 4 and semiconductor driving chips 2. Therefore, all the components have an identical thermal expansion coefficient, thereby eliminating degradation of mechanical alignment accuracy. The accuracy of mechanical alignment would be degraded if there were any differences in the thermal expansion coefficients of the components if the temperature changed during the assembling process.

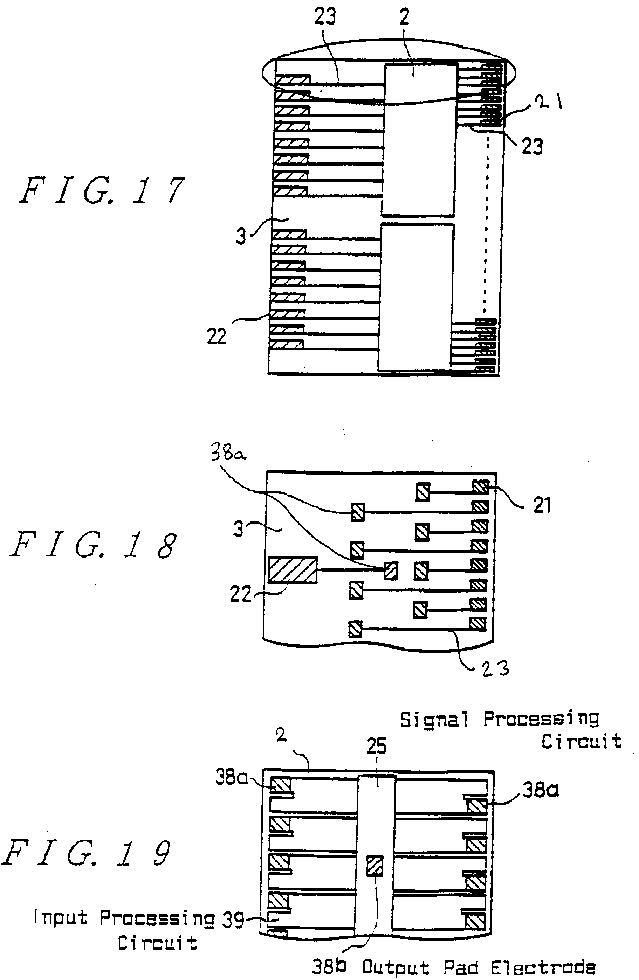

Figs. 17 , 18 and 19 show the detailed pattern arrangement of the driver substrate 3 used in the Fig. 1 embodiment. Fig. 17 is a detailed plan view showing a semiconductor driving chip 2 mounted by facedown bonding on the driver substrate 3 for driving the semiconductor image sensor device. Fig. 18 is a enlarged partial plan view showing an encircled portion in Fig. 17, of the driver substrate 3, in a vertically expanded manner, before mounting the semiconductor driving chip 2. Fig. 19 is an enlarged partial plan view showing an active face, i.e., rear face of the semiconductor driving chip 2. Though the pitch of the junction electrodes 21 (line electrodes) is enlarged for illustrative purpose in Figs. 17 and 18, the pitch is much narrower in practice, in the order of 50 µm.

In this embodiment, the driver substrate 3 comprises a silicon wafer having opposed major faces, which are formed with pad electrodes 20 of gold bumps for electrical connection to opposed pad electrodes 38a of the semiconductor driving chip 2 when mounted in the facedown manner. Each pair of driving chips 2 are mounted on top and rear faces of the driver substrate 3. The junction electrodes 21 are arranged closely at a pitch of 50 µm corresponding to that of the sensing lines or strip lines of the adjacent sensor chip. The junction electrodes 21 are connected to the strip lines formed on the adjacent semiconductor image sensor chip 1 in one-to-one manner through a coupling chip 4, as will be described later. For this, the pitch of junction electrodes 21 is set equal to that of the strip or sensing lines.

As shown in Fig. 19, the semiconductor driving chip 2 is formed with input pad electrodes 38a for receiving signals from the semiconductor image sensor chip 1 and an output pad electrode 38b for outputting a signal processed in the driving chip 2.

Conventionally, the driving chip 2 and the driver substrate 3 are electrically connected by wire bonding. In such a case, bonding must be carried out around the periphery of the driving chip 2. Further, in view of the desire to have uniform electric performance for suppressing any resistance difference among lead patterns on the driver substrate, the pad electrodes must be aligned in a line along the junction electrodes 21. Therefore, the pad electrode pitch is equal to or less than the sensing line electrode pitch. Consequently, wire bonding must be carried out at most at 50 µm intervals.

In contrast, in this embodiment, the input pad electrodes 38a can be arranged in a staggered manner with respect to the junction electrodes 21, and the output pad electrodes 38b are formed centrally of the semiconductor driving chip 2. The input pad electrodes 38a are disposed in a staggered manner along opposed sides of the chip: hence the electrode pitch is made twice as wide as achieved in the prior art when using wire bonding. This thereby facilitates the mount work. In addition, the lead patterns are arranged on the driver substrate 3 under the driving chip 2 in a regular manner, thereby avoiding degradation of electric performance.

As shown in Fig. 18, the driver substrate 3 is formed with pad electrodes 20 corresponding to the input and output pad electrodes 38a, 38b of the driving chip 3. As shown in Fig. 19, input processing circuits 39 are disposed adjacently to each input pad electrode 38a to function as an input buffer. A signal processing circuit 25 composed of a multiplexer and an A/D converter etc is disposed centrally to connect to the respective input processing circuits 39. The circuit 25 has terminals in the form of control output pad electrodes 38b for receiving power and a control signal such as a clock etc and for transmitting a converted digital data output.

In this embodiment, the semiconductor driving chip 2 operates to drive the semiconductor image sensor chips 1 and to process signals from the sensor chips for transmitting information from the image sensor chips 1 to an external system. The driver substrate 3 is provided with the junction electrodes 21 on the top and rear faces thereof adjacent to the next sensor chip for electrical connection. In the embodiments of the present invention, two semiconductor chips 2 are described, but it is not restricted to just two, but three, four, or five chips may be used to cover the whole range. The number of chips is determined by the IC production capacitity and the mounting cost.

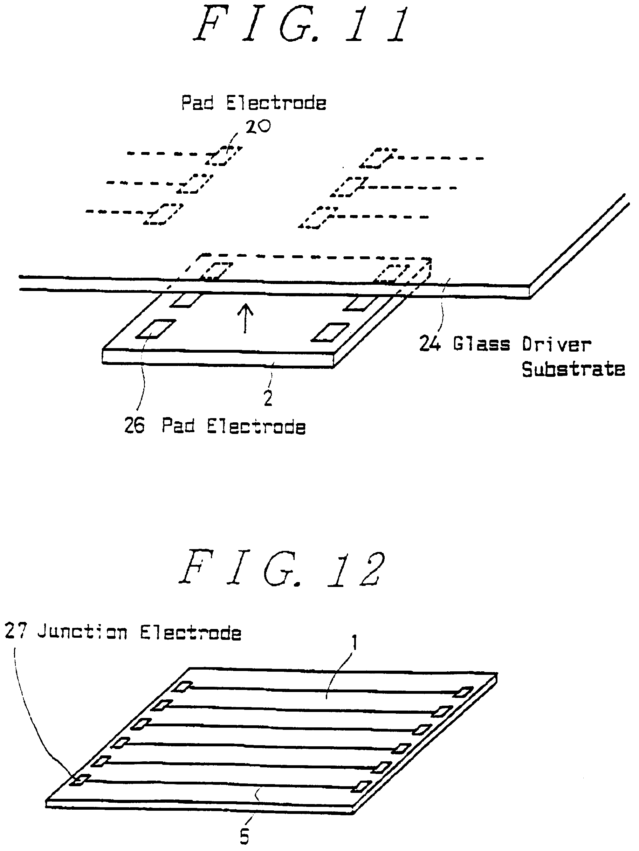

Referring to Fig. 11, a glass driver substrate 24 is shown which may be used in place of the monosilicon driver substrate 3a in the Fig. 1 embodiment. The driver substrate 24 comprises a glass plate having opposed major faces, which are formed with lead patterns and pad electrodes by an aluminium film process. In Fig. 11, lead patterns are illustrated only on the rear face for better understanding, and other patterns are eliminated from the top face. In this embodiment, an active face of the semiconductor driving chip 2 is directly viewed through the glass driver substrate 24, so that pad electrodes 20 can be aligned to corresponding pad electrodes 26 of the driving chip 2 by direct observation to thereby facilitate mounting. The glass driver substrate 24 may be composed of a pyrex glass having a thermal expansion coefficient comparable to that of the monosilicon in the range of room temperature to 500°C, thereby avoiding degradation of mechanical alignment accuracy due to any thermal expansion rate difference.

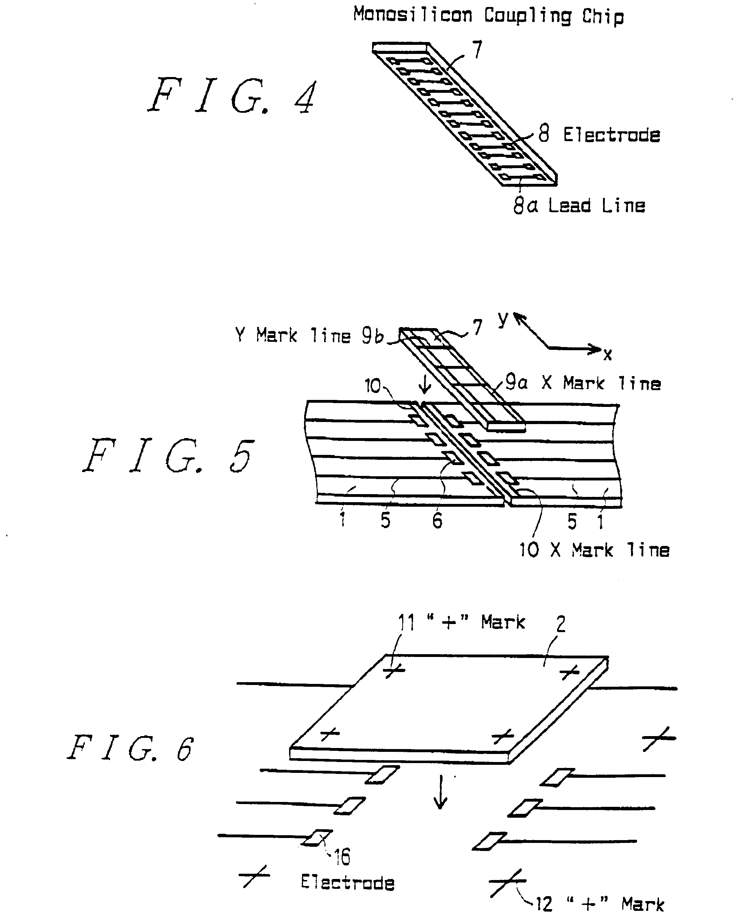

The description will now turn to the mechanical and electrical coupling between adjacent sensor chips 1 and between an end sensor chip 1 and the driver substrate 3. Fig. 2 is an enlargedtop view showing a coupling portion between a pair of adjacent semiconductor image sensor chips 1 in the Fig. 1 embodiment. Fig. 3 is an enlarged side view corresponding to the enlarged top view of Fig. 2. Further, Fig. 4 is a perspective rear view showing the coupling chip 4 appearing in Figs. 2 and 3 which comprises a monosilicon chip 7.

In the construction shown in Figs. 2 and 3, the semiconductor image sensor chip 1 and the coupling chip 4 are electrically connected to each other such that the junction electrodes of both chips are superposed on each other. As shown in Fig. 2, the semiconductor image sensor chip 1 is formed on its top and rear faces with sensing lines 5 at a constant pitch. Electrodes 6 (Fig. 3) are provided at the ends of the respective sensing lines 5 in the form of a gold bump for external electrical connection (not shown in Fig. 2). In turn, as shown in Fig. 4, the coupling chip is provided with lead lines 8a and corresponding junction electrodes 8 on one face, which is opposed to the semiconductor sensor chip 1, at the same pitch as that of the sensing lines 5. Each junction electrode 8 is composed of a gold bump for electrical contact with the corresponding junction electrode 6 formed on the semiconductor image sensor chip 1. The electrical connection is made therebetween such that the opposed bumps are fused to each other by a gold/gold eutectic bond. Alternatively, the electrical coupling may be provided by using an electroconductive adhesive of an anisotropic type containing electroconductive particles in an adhesive material.

In the construction shown in figures 2 & 3, the electrical coupling and mechanical coupling are concurrently carried out in the semiconductor image sensor device. With regard to the electrical connection, in contrast to the conventional wire bonding method, all the junction electrodes are coupled at once, thereby significantly reducing the numbers in the assembling process. Further, after the coupling treatment, the junction electrodes and lead lines involved in the coupling portion are concealed and protected under the coupling chip 4, thereby improving reliability and quality of the electrical connection.

Fig. 5 illustrates how the monosilicon coupling chip 7 is accurately aligned to the junction electrodes 6 of the image sensor chip 1. Namely, when the monosilicon coupling chip 7 is superposed on the sensor chips 1, both of the junction electrodes are concealed and hidden from view. In view of this, an X mark line 9a and a Y mark line 9b are provided on a top face of the monosilicon coupling chip 7. When aligning the chips, the X mark line 9a is aligned to correspond to an X mark line 10 formed on the sensor chip 1. Similarly the Y mark line 9b is aligned to correspond to a sensing line formed on the image sensor chip . The aligned chips thus register the opposed and concealed junction electrodes with each other. After alignment, mechanical and electrical coupling is effected by gold/gold eutectic bonding between opposed gold bumps, or by anisotropic electroconductive adhesive to thereby mechanically and electrically unite the adjacent semiconductor image sensor chips 1 with each other.

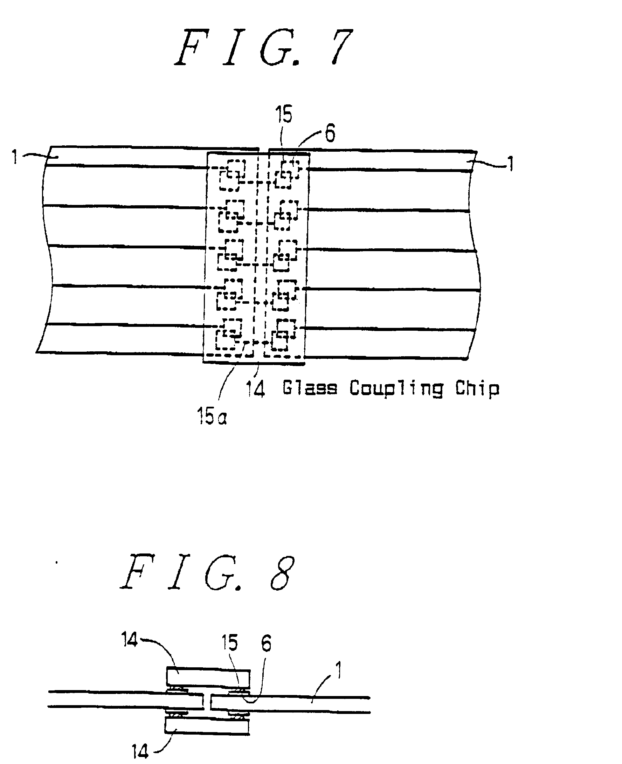

Fig. 7 shows a glass coupling chip 14 which may be used as the coupling chip 4 connecting between the adjacent sensor chips 1 in the Fig. 1 embodiment. This figure shows a superposed state before alignment. Fig. 8 shows an aligned state of the same. Further, Fig. 9 shows a perspective view of the glass coupling chip 14. In Fig. 8, the pair of semiconductor image sensor chips 1 are electrically coupled to each other by the intermediate glass coupling chip 14 while opposed junction electrodes are registered with each other. As shown in fig. 7, before alignment, the electrodes 6 of the sensor chip 1 are dislocated from the corresponding electrodes 15 of the glass coupling chip 14. Sensing lines 5 are arranged on the top and rear faces of the sensor chip 1 at a given constant pitch. Pad or junction electrodes 6 are disposed at both ends of each sensing line 5 for external electric connection. Further, as shown in Fig. 9, the glass coupling chip 14 is formed with lead patterns 15a and electrodes 15 on one face at the same pitch and which is opposed to the sensor chip 1.

In Figs. 7 and 9, the portions indicated by a dashed line are viewed through the transparent glass of the coupling chip 14. During alignment, the electrodes 15 and lead patterns 15a arranged on the coupling chip 14 can be viewed through the transparent glass and superposed to correspond to electrodes and lead patterns of either of the sensor chip 1 and driver substrate 3. This thereby facilitating alignment of the chips. These components may be assembled together by, for example, an anodic bonding method. This method disposes the glass coupling chip 14 on the monosilicon sensor chip 1 and driver substrate 3 or chips 1, while a high voltage, of about several hundreds volt, is applied between the glass and monosilicon components, for heating the components to about 400°C. Consequently, the glass plate is mechanically bonded to the silicon plate. Such a method will be described later in detail.

When the silicon and glass plates are coupled to each other by anodic bonding, the electrodes 15 on the glass coupling chip 14 are pressed to the corresponding electrodes 6 of the sensor chip 1 to ensure electrical connection. Fig. 8 shows such an electrical connection where quite thin films of the opposed electrodes 6, 15 are superposed with each other. Accordingly, anodic bonding can carry out concurrently both the electrical and mechnical couplings. With respect to the electrical connection, all of the electrodes can be processed at once to thereby reduce fabrication steps as opposed to the wire bonding method. Further, the electrodes and lead patterns are concealed under the coupling chip 14 to thereby protect the coupling portion to improve reliability of the connection, in similar manner to that discussed previously.

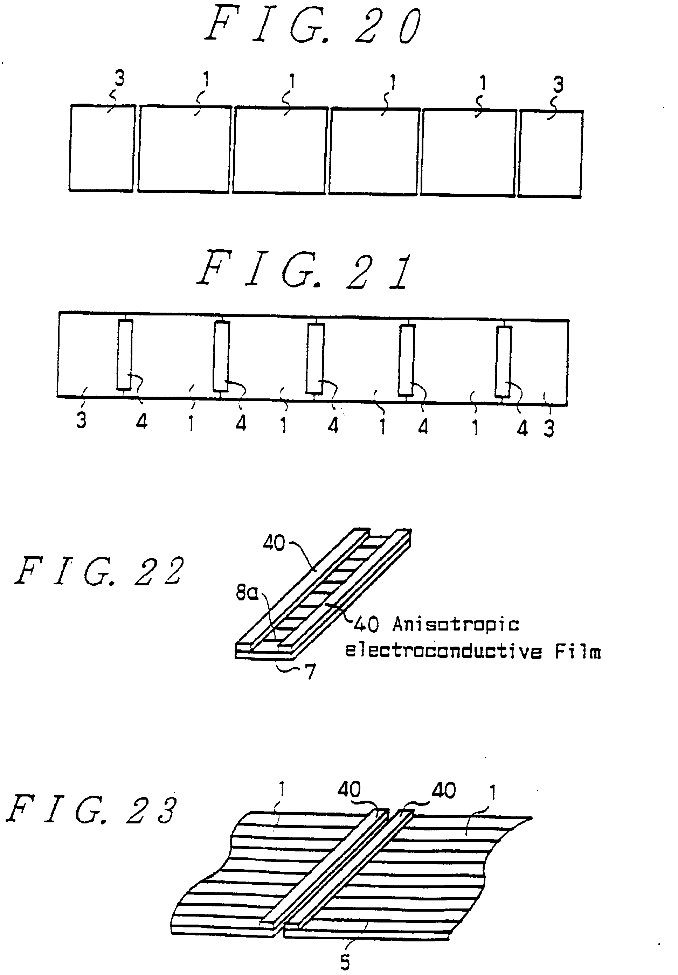

The description will now turn to a method of producing the Fig. 1 embodiment. Fig. 20 is a top plan view showing the relative alignment of the semiconductor image sensor chips 1 and the driver substrates 3 of the inventive semiconductor image sensor device. Namely, this figure shows a first step of the production method of the inventive device. In this embodiment, four pieces of semiconductor are aligned in the lengthwise direction of the device forming the semiconductor image sensor chips 1 such that respective coupling portions are disposed adjacent to each other. The pair of driver substrates 3 are aligned at opposite ends of the serially aligned chips 1 such that the coupling portion of each driver substrate 3 is disposed adjacent to the neighbouring semiconductor image sensor chip 1. These chips 1 and substrates 3 are aligned relative to one another such that coupling chips 4 (not shown) can be aligned with the junction electrodes formed on the sensor chips 1 and driver substrates 3. Alignment is carried out such that an aligning arm is operated to displace the chips and substrates while monitoring the position of the lead and electrode patterns from the top view. Alternatively, a chip mounting tool may be utilized for the alignment.

Fig. 21 is a top plan view showing a second step of producing the inventive semiconductor image sensor device, in which the semiconductor image sensor chips 1 and the driver substrates 3 are connected to each other by means of the coupling chips 4. The coupling chips 4 can be selected from either of the monosilicon coupling chips 7 or the glass coupling chips 14. The coupling chip 4 is formed on one face thereof with lead lines 8a, 15a and junction electrodes 8, 15 (not shown). The coupling chip 4 is placed in a facedown manner such that the junction electrodes 8, 15 are aligned in contact with corresponding junction electrodes formed on either of the sensor chip 1 or driver substrate 3 so as to effect facedown bonding. By this step, the four semiconductor image sensor chips 1 and the two driver substrates 3 are mechanically united with each other, though the semiconductor driving chips 2 are not yet mounted and rear coupling has not yet been carried out on the rear face of the device. Consequently, even if an external force is applied thereafter, the semiconductor image sensor chips 1 and the driver substrates 3 can be prevented from dislocation. A third step is then carried out such that semiconductor driving chips 2 are mounted on the top faces of the driver substrates 3 disposed at opposite ends of the device. Thereafter, other coupling chips 4 are used to effect coupling on the rear face for the already aligned components. Lastly, other semiconductor driving chips 2 are mounted on the rear face of the driver substrates 3, thereby completing the semiconductor image sensor device as shown in fig. 1.

The description will now turn to a bonding method for the coupling chips using an anisotropic electroconductive adhesive. Fig. 22 is a perspective view showing an anisotropic electroconductive film 40, which is one kind of anisotropic electroconductive adhesive, disposed on the monosilicon coupling chip 7. As shown in the figure, the film 40 is temporarily fixed by thermally pressing onto the junction electrodes of the monosilicon coupling chip 7. The junction electrodes may be alternatively adopted in the fig. 1 embodiment of the inventive semiconductor sensor device. Further, a glass coupling chip may be used in place of the monosilicon coupling chip. In the second step as described before, the anisotropic electroconductive film 40 is shaped in a desired form, and is provisionally and temporarily fixed to the junction electrodes 8, 15 of the lead lines 8a, 15a formed on the coupling chip 7, by applying pressure and heat.

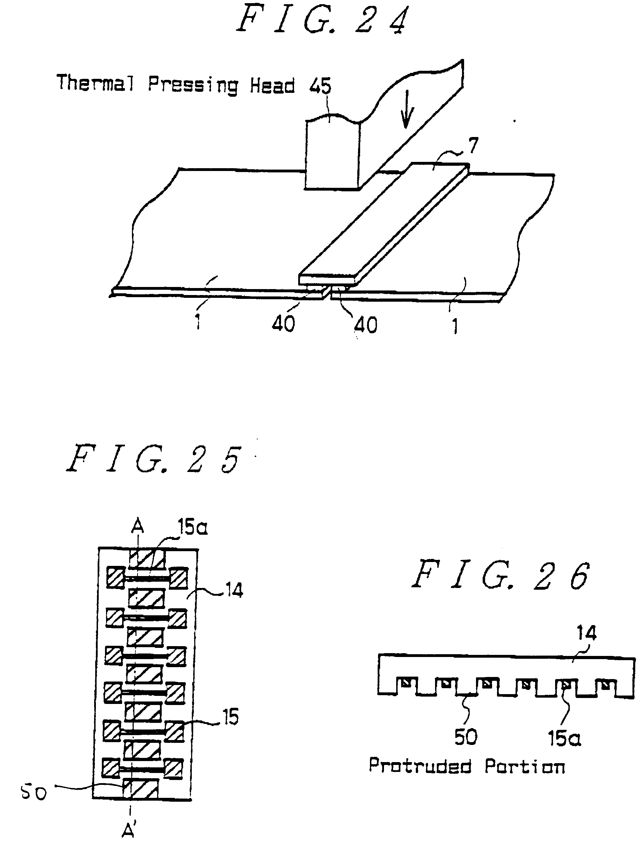

Referring to fig. 23, in a manner similar to fig. 22, other anisotropic electroconductive films 40 are temporarily pressed and fixed to a connecting portion of each semiconductor image sensor chip 1. Thus the preparing step of the coupling, in this manner includes the anisotropic electroconductive adhesive being applied to one or both of the coupling chip, and the semiconductor image sensor chip 1 and driver substrate 3.

At this point, a detailed description is given for the anisotropic electroconductive film 40. The film 40 comprises a double sided adhesive tape having a thickness in the order of 20 - 30 µm and having sticky opposite faces. This adhesive tape is sandwiched by a pair of parting lines, and is generally wound around a reel. The adhesive tape is composed of a matrix resin, such as an epoxy, containing electroconductive particles having a diameter in the order of several µm to several tens µm.

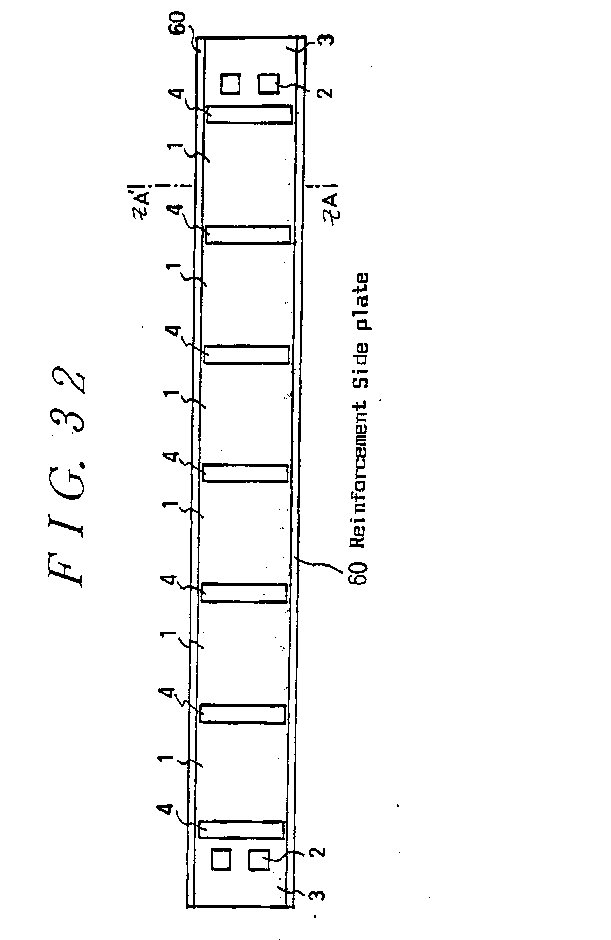

Referring to Fig. 31, for explanatory purpose, the semiconductor driving chip 2 is mounted on the driver substrate 3 by means of the anisotropic electroconductive film 40. The driving chip 2 is disposed on the driver 3 through the anisotropic electroconductive film 40 such that electrodes of the chip 2 are aligned to correspond to lead patterns 13 of the driver substrate 3. Thereafter, heat and pressure are applied therebetween so that the anisotropic electroconductive film 40 is compressed. Thus the electroconductive particles 56 are directly contacted to both of the electrodes 8 and the electrodes 16 to make electrical conduction therebetween. However, the electroconductive particles 56 do not contact with each other in the horizontal direction to provide insulation. That is to say, the anisotropic electroconductive film 40 is electroconductive in the vertical direction and an insulative feature in the horizontal direction.

The anisotropic electroconductive film 40 may vary depending on the kind of organic adhesive material used, the thickness of the film, the kind of electroconductive particle and the density of the particle. Two types of anisotropic electroconductive films have been tested for bonding the coupling chip 4 and the image sensor chip 1 having gold bump electrodes which have a height of 10 µm and an area of 100 µm by 40 µm. The test results are shown in the following table. Each sample contains 1280 junction electrodes.

**Table**

| ADHESIVE MATERIAL | FILM THICKNESS | COMPOSITION OF ELECTRO-CONDUCTIVE PARTICLE | PARTICLE DENSITY | PASS RATE |
|---|---|---|---|---|
| EPOXY | 25 µm | Plastic particles plated by gold, and having 5 µm diameter | 8% | 98% |
| EPOXY | 25 µm | Plastic particles plated by gold, and further coated by an insulative film, and having 5 µm diameter | 32% | over 99,9% |

As shown in the table, the first anisotropic electroconductive film has a rather low density of particles, hence the test pass rate is not so high. On the other hand, the second film has an increased particle density so that the test pass rate reaches a practical level. In the second film composition, the electroconductive particles are coated by an insulative film to avoid horizontal conduction and also an increase in the density. This insulative coating is easily broken on contact with the electrode or lead pattern when applied with heat and pressure, to thereby provide electrical conduction in the vertical direction.

Referring to Fig. 24, in this embodiment of the inventive semiconductor image sensor device, a pair of semiconductor image sensor chips 1 are coupled by one monosilicon coupling chip 7 having the anisotropic electroconductive films 40. The pair of semiconductor image sensor chips 1 and the monosilicon coupling chip 7 are positioned relative to each other such that opposed junction electrodes are registered with each other. The anistropic electroconductive film 40 is interposed between the opposed junction electrodes. In such an arrangement, a heated thermal pressing head 45 is lowered to a connecting portion to apply pressure thereto so as to achieve both electrical conduction and mechanical connection between the pair of semiconductor image sensor chips 1.

This treatment may be also applied to connection between semiconductor image sensor chips 1 and the driver substrate 3, and to coupling on the rear face of the device. The use of the anisotropic electroconductive adhesive can significantly lower the processing temperature as compared to the gold/gold eutectic bonding. The anisotropic electroconductive adhesive requires a processing temperature of less than 200°C, while the gold/gold eutectic bonding requires a processing temperature of 400 - 500 °C. Accordingly, the coupling process of such a type can improve workability and safety of the device production, and can prevent degradation of quality of the respective components in the semiconductor image sensor device. Alternatively, a glass coupling chip may be used in place of the monscilicon coupling chip for electrically and mechanically bonding the semiconductor image sensor chip 1 by the anodic bonding method, as described before.

Figure 6 shows an alternative method of mounting the semiconductor driving chip 2 on the driver substrate 3. The driving chip 2 is formed such that on its top face 2a there are four visually recognized marks "+" 11. These "+" marks 11 can be patterned so as to align with the patterns and electrodes formed on the active rear face thereof and with relatively high accuracy of less than several µm by using a two-face aligner. The mark can be selected from a rectangle, a triangle and other shapes instead of the "+" mark. In any case corresponding marks are provided, i.e. four "+" marks 12, on the driver substrate 3 for determining the correct position of the driving chip 2 with reference to the "+" marks 11. Initially, the driving chip 2 is placed near the correct position on the driver substrate 3 while the active face of the driving chip 2 is opposed to the driver substrate 3. Then by visually recognising both the "+" marks 11, 12, the position of the driving chip is adjusted. Consequently, the electrodes 16 of the driver substrate 3 are matched to corresponding electrodes formed on the active face of the driving chip 2. In this operation, visual recognition is achieved by directly viewing both the chip and substrate marks 11, 12 through a video camera to enable accurate mounting of the driving chip having very high integration density. After the mounting, the relative position between the chip and substrate marks 11, 12 are measured to check the mounting accuracy.

Figure 12 shows one example of a semiconductor image sensor chip 1. The sensor chip 1 is formed with sensing lines 5 and junction electrodes 27. When the sensor chip 1 is bonded by the coupling chip 4 as shown in Figures 1, 2 and 3 by facedown bonding, the junction electrodes 27 and the lead lines are concealed under the coupling chip 4. Accordingly, some difficulties may be caused. Firstly, it would be difficult to undertake any electrical conduction check for individual connecting points after bonding and secondly, it would be difficult to repair a contact defect.

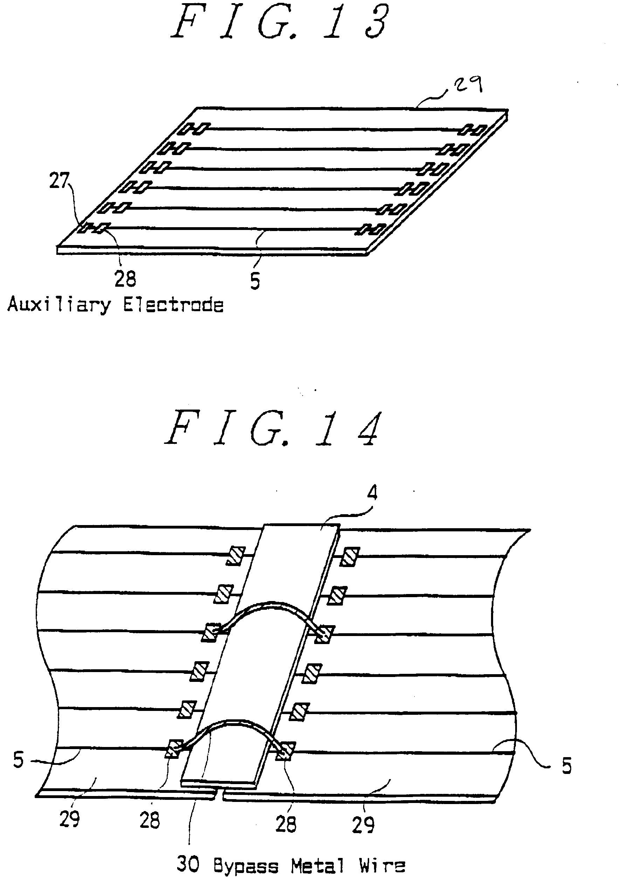

In view of the above noted drawbacks, Figure 13 shows another example of a semiconductor image sensor chip 29; in this case having auxiliary electrodes. The auxiliary electrodes 28 are formed adjacent to the corresponding junction electrodes 27 at the end of the respective sensing lines 5, and are located in an exposed area not covered by the coupling chip. As shown in Figures 14, 15 and 16, the auxiliary electrodes 28 are used for electrical conduction checks and repair of contact defects.

Figure 14 shows one method of repairing a contact defect when a pair of sensor chips 29 are coupled by a coupling chip 4. In this embodiment, the conduction check is carried out and found for example that there are initial contact defects at the first line and the fourth line. Then, a bypass metal wire 30 is connected between the corresponding auxiliary electrodes 28 involved in the contact defect across the coupling chip 4 by means of wire bonding. The bypass metal wire thus recovers any contact or conduction defect. By repairing the initially defective image sensor device, a good device can be salvaged which can operate normally. The bypass line 30 can be connected alternatively by soldering or using conductive adhesive and not just wire bonding. The effective repair can raise yield rates to realize a reduction in the production time and production cost. It can also realize maintenance in the field.

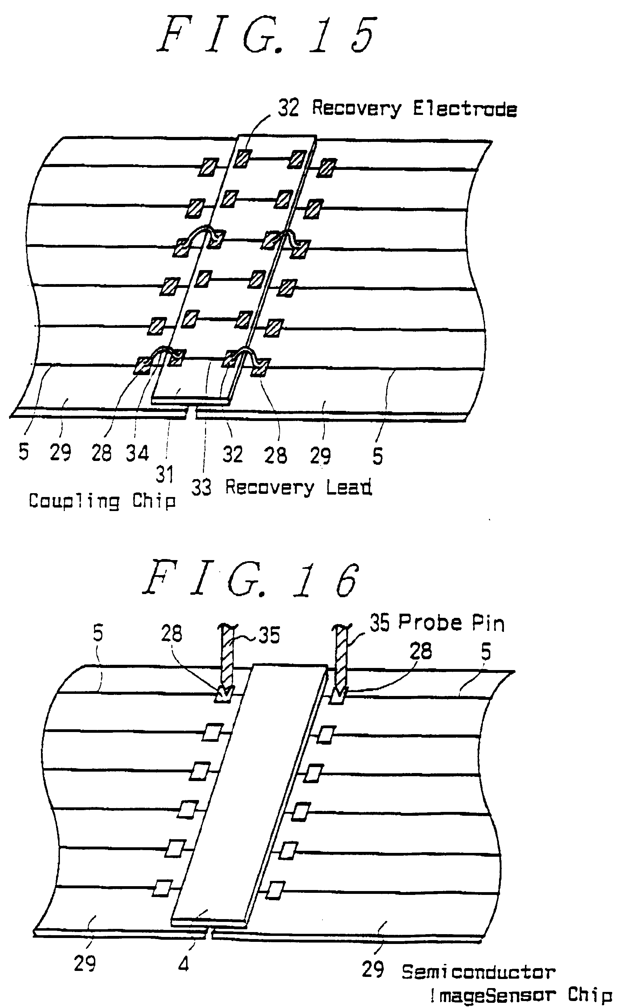

Figure 15 shows another way of repairing contact defects using the sensor chip 29 having auxiliary electrodes. This embodiment is different from the Figure 14 embodiment in that the coupling chip 31 is formed on its top face with recovery leads 33 and recovery electrodes 32 in a corresponding manner to the sensing lines 5. For example, consider when the device has initial contact defects at the first and fourth lines. Then, the auxiliary electrodes 28 involved in the contact defects are connected to the adjacent recovery electrode 32 at opposite sides of the coupling chip 31 to repair the defective part. By this, a signal path is established along the sensing line in the defective part from the right sensor chip to the left sensor chip through a sensing line 5. That is to say from an auxiliary electrode 28, to a bypass wire 34, to a recovery electrode 32, to a recovery lead 33 to another recovery electrode 32, to another bypass wire 34, to another auxiliary electrode 28 and to the other sensing line 5. On the other hand, a regular signal path is established through a sensing line 5, or a junction electrode 27 of the sensor chip (concealed), a corresponding junction electrode of the coupling chip (concealed), another junction electrode of the coupling chip (concealed), another corresponding junction electrode of the other sensor chip (concealed), and to another sensing line 5. The recovery electrode and recovery lead may have various shapes, compositions and location. For example, a large central recovery electrode may be formed on the top face of the coupling chip for providing an intermediate spot while eliminating the recovery leads. The use of a recovery electrode can reduce the length of the bypass wire as compared to the direct bypass between the pair of separate auxiliary electrodes, thereby facilitating repair work by using a regular wire bonding machine, and improving reliability.

Figure 16 shows a method of checking conduction using the auxiliary electrodes 28 after the pair of semiconductor image sensor chips 29 are connected to each other by the coupling chip 21. In this embodiment, a pair of probe pins 35 contact a corresponding pair of auxiliary electrodes 28 along one sensing line 5 across the coupling chip 4 to measure the junction resistance to effect a conduction check. All of the sensing lines 5 are sequentially subjected to the conduction check by using the probe pins 35 to thereby identify a defective part. Thereafter, the defective part is repaired as shown in Figures 14 and 15. Further, the auxiliary electrodes 28 may be utilized for measurement of the electrical characteristics of the junction part and for maintenance. Any check method can be adopted to detect the conduction between pairs of separate auxiliary electrodes 28. The manner of repairing and checking using the auxiliary electrodes 28 as shown in Figures 13, 14 and 15 can be applied to the coupling between the sensor chip 1 and the driver substrate 3 by preparing similar auxiliary electrodes on the driver substrate 3.

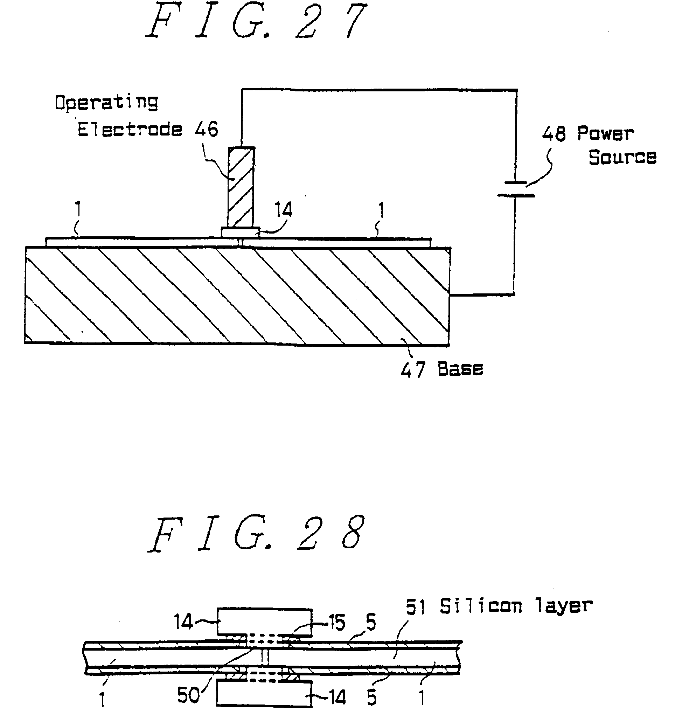

The description will now turn to the anodic bonding used in the present invention. Referring to Figure 27, the glass coupling chip 14 is chemically bonded to the semiconductor image sensor chip 1 by anodic bonding. Firstly, a power source 48 is connected between a base 47 composed of conductive material, such as metal, and an operating electrode 46 such that a negative voltage is applied to the operating electrode 46 and a positive voltage is applied to the base 47. Further, the base 47 is heated at about 400°C, and a pair of semiconductor image sensor chips 1 composed of a silicon wafer are disposed on the base 47. Further, a glass coupling chip 14 composed of pyrex glass is disposed on the pair of sensor chips 1. Then, the operating electrode 46 contacts the glass coupling chip 14 to apply a voltage of about 400 V across the glass coupling chip 14 and the pair of semiconductor image sensor chips 1 at a temperature of 400°C. Therefore, contact between the silicon and the glass is subjected to an electric field. Under such conditions sodium ions (Na⁺) are drawn upward toward the operating electrode 46 so that only silicon atoms are left around the contact portion, whereby both the silicon layers are adhered to each other to effect mechanical unification. This is the basic principle of anodic bonding. Needless to say, the surfaces of both parts must be made smooth and clean for stable bonding.

Figures 25 and 26 show an example of a glass coupling chip 14 for bonding the semiconductor image sensor chips 1 by anodic bonding. Figure 25 is a plan view, and Figure 26 is a sectional view taken along the line A-A' of Figure 25. Protruded portions 50 which are shown as hatched in Figure 25, are made relatively higher by 2-3µm as compared to the remaining portions containing lead lines 15a, as indicated in Figure 26. The remaining portions have the same level, formed with the lead lines 15a and electrodes 15. Figure 28 is an enlarged partial section taken along the lengthwise direction, showing the electrical and mechanical coupling between the glass coupling chip 14 of the Figures 25 and 26 structure, and the pair of semiconductor image sensor chips 1. The glass coupling chip 14 contacts at its protruded portions 50 to a silicon layer 51 of the sensor chips 1 such that both of the layers are chemically united by anodic bonding. By the bonding force between both the parts, the sensing lines 5 comprising aluminium, on the sensor chips 1 are mechanically pressed to electrodes 15 of the glass coupling chip 14 thereby providing electrical connection.

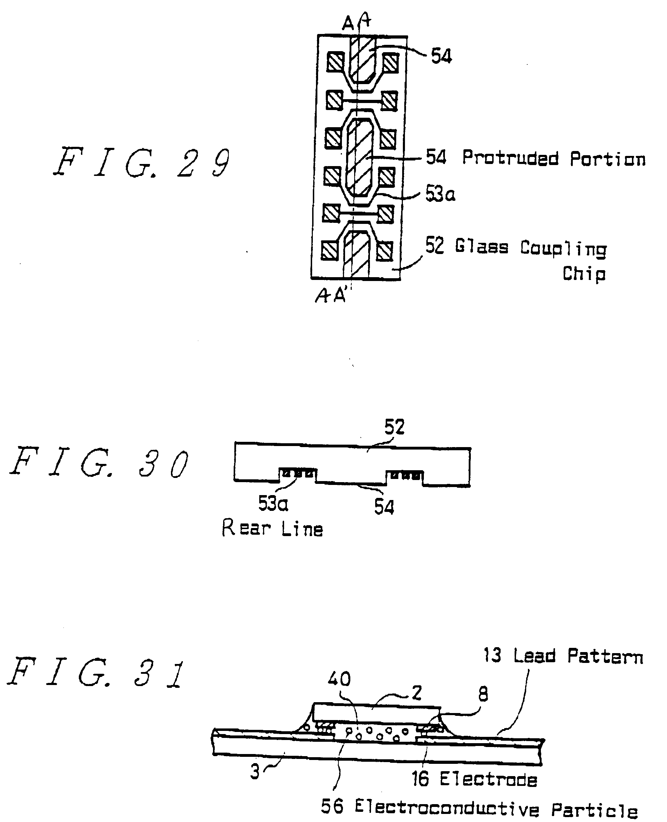

Figure 29 shows another example of a glass coupling chip 52 which is different from the Figure 25 glass coupling chip 14. Figure 30 is a sectional view thereof taken along the lines AA-AA'. In contrast to the prior example of Figures 25 and 26, a set of three lead lines 53a is passed between adjacent protruded portions 54 in order to increase the area of protruded portions 54. By such an arrangement, one can obtain a larger bonding area to improve stability and strength of the bonding, as compared to the Figures 25 and 26 example.

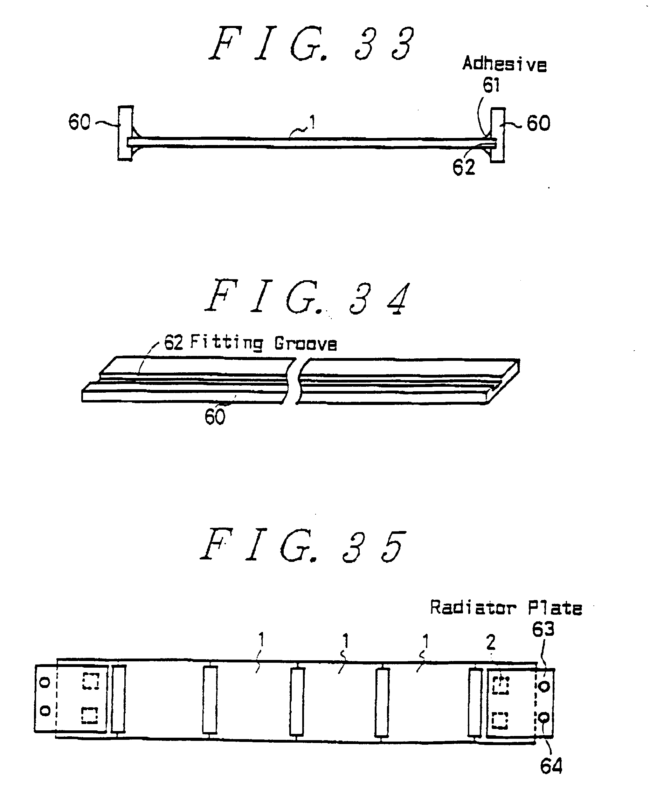

Figure 32 is a top plan view showing another embodiment of the invention. Figure 33 is a sectional view taken along the line ZA-ZA' of Figure 32. Further, Figure 34 is a perspective view showing the shape of a reinforcement side plate 60 used in the Figure 32 embodiment. This embodiment is different from the Figure 1 embodiment in the following aspects. First, six semiconductor image sensor chips 1 are connected together in series. Second, the pair of reinforcement side plates 60 are fixed widthwise to opposite sides of the semiconductor image sensor device by an adhesive 61 of room temperature curing type, as shown in Figure 33, for improving the mechanical strength. In contrast to the Figure 1 embodiment, the present embodiment has a greater overall length so that the strength and rigidity of the semiconductor image sensor device is inferior to the Figure 1 embodiment. Thus, the device may suffer from drawbacks such as deficiency of strength and bending or stress of workpieces. In order to remove these drawbacks, the reinforcement side plate 60 is adopted in this embodiment.

The reinforcement side plate 60 has a length the same as the overall length of the semiconductor image sensor device, and is shaped into a thin and elongated planar piece. A fitting groove 62 is formed therein for guiding the side plate 60 in engagement with those of the semiconductor image sensor chips 1 and driver substrates 3. The fitting groove 62 cannot only stabilize widthwise the positioning of those components relative to the side plate 60, but also can serve as a container for reserving a sufficient amount of the adhesive to ensure practical adhesion strength. The reinforcement side plate 60 may be composed of a different material than silicon which constitutes those of the sensor chip 1 and driver substrate 3. In view of this, the adhesive 61 may be of the room temperature curing type which can eliminate any ill affects of thermal expansion difference in the curing process of the adhesive. Although the pair of side plates 60 having the fitting groove 62 are utilized as a supplementary reinforcement member such that each side plate 60 is fixed by means of the adhesive 61 of the room temperature curing type in this embodiment, other alternatives may be adopted as follows. First, as far as the reinforcement plate does not affect the light receiving area and does ensure the needed strength, the shape and position of the reinforcement plate is not limited to the disclosed embodiment. Second, instead of using the adhesive for fixing, other methods may be adopted such that, for example, the reinforcement side plate may be tightly engaged to the side of the semiconductor image sensor device through the fitting groove to thereby mechanically unite both the parts with each other.

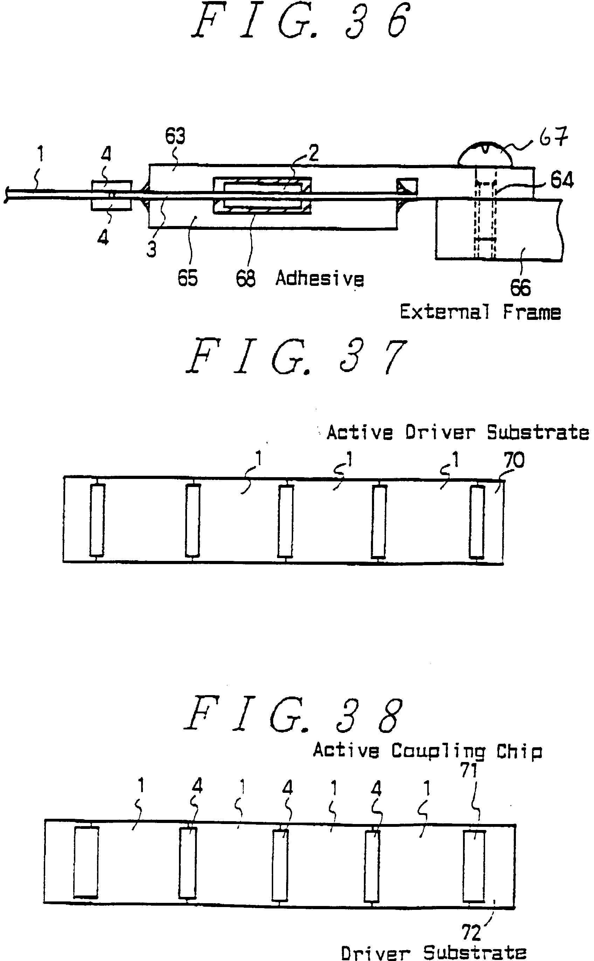

Figure 35 shows a further embodiment of the inventive semiconductor image sensor device. Namely, a radiator plate 63 is attached to the driver substrate 3 for removing heat generated by the driving chips 2 to avoid unstable operation due to increases in temperature. Further, Figure 36 is an enlarged section showing a portion where the radiator plate 63 is attached to the sensor device and to an external frame 66. The upper radiator plate 63 is fixed to the driver substrate 3 by an adhesive 68 to enclose the semiconductor driving chips 2. The radiator plate 63 is further formed with one or more holes 64 for fixing the semiconductor image sensor device to the frame 66 by means of screws 67. Thus, the radiator plate 63 has two functions for radiating heat and for fixing the device to the frame 66 to support the device. Thus this reduces the number of components and the number of assembling steps. With a double sided device, other semiconductor driving chips 2 are mounted on the rear face and hence a lower radiator plate 65 is attached in a similar manner. While the upper radiator plate 63 is used for the frame fitting, the lower radiator plate 65 has a size slightly smaller than the driver substrate 3. The radiator plate is preferably composed of, for example, an aluminium alloy having good thermal conductivity, high strength and high accuracy of dimension. The shape of the radiator plate is determined by the relationship between the amount of heat generated by the driving chip 2 and the amount of heat which can be radiated at the fitting structure of the frame, the size of the driving chip 2 and driver substrate 3, the positional relation and the dimension of an escape portion.

Figure 37 shows a still further embodiment of the inventive semiconductor image sensor device. In this embodiment, the driver substrate is composed of a monosilicon plate integrally formed thereon with active elements for driving the image sensor chips 1. That is to say, the active driver substrate 70 is used in place of the driver substrate 3 of Figure 1 which mounts thereon a semiconductor driving chip 2. The active driver substrate 70 is used to eliminate a driving chip and to achieve the following advantages. First, chip mount to the driver substrate is eliminated to thereby reduce the number of components and the number of assembly steps. Further, defects in the chip mount and degradation of the coupled portion may be eliminated to thereby improve yield rate and reliability. Second, the dimensions of the driver substrate can be designed without regard to the space for the chip mount to thereby enable reduction of the substrate size. Third, the radiator plate is attached to cover a step portion on the substrate, thereby eliminating an escape work on the radiator plate to increase the contact area to improve the bonding strength and the heat radiation capacity and to simplify the shape of the radiator plate.

In modification of the Figure 37 embodiment, the function of the driving chip may be divided into an external supplementary chip and the driver substrate. Stated otherwise, the driving function is shared by the supplementary chip and the driver substrate. In such a case, integration density of the supplementary chip can be lowered as compared to the complete driving chip of Figure 1, as well as integration density of the driver substrate can be lowered as compared to that of the complete active driver substrate of Figure 37, thereby improving yield rate of the respective elements.

Figure 38 shows a still further embodiment of the inventive image sensor device. In this embodiment, an active coupling chip 71 formed with a driving circuit is used to couple an end sensor chip 1 and a driver substrate 72, thereby eliminating a driving chip from the driver substrate 72. The use of the active coupling chip 71 achieves the following advantages. First, the driving chip can be eliminated to thereby reduce the number of components and the number of assembly steps. Second, the layout of the driver substrate can be designed free of any driving chip mount space to thereby reduce the size of the driver substrate. Third, the signal from the sensor chips 1 through the sensing lines is processed once and then transmitted to the driver substrate 72, thereby reducing the number of electrodes formed on the driver substrate 72, to be smaller than the number of sensing lines. By this, the driver substrate 72 has a broad electrode pitch and a wide electrode area to thereby facilitate and ensure good electrical connection.

In modification of the Figure 38 embodiment, a supplementary driving chip may be mounted on the driver substrate such that the driving function is shared by the supplementary driving chip and the active coupling chip. Alternatively, the active coupling chip may be combined with the active driver substrate. Further, the active coupling chip may be directly connected to an external system to thereby eliminate a driver substrate.

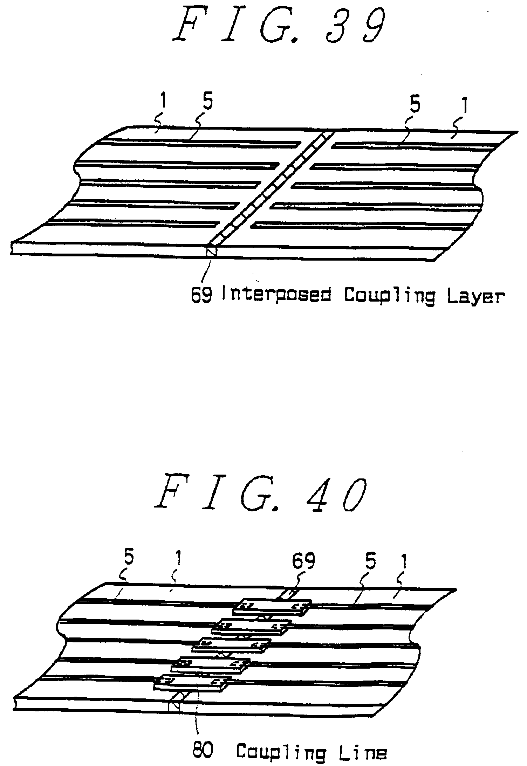

In the aforementioned description of the various embodiments, either the monosilicon coupling chip 7 or the glass coupling chip 14 is utilized to connect between adjacent sensor chips 1, and between a sensor chip 1 and a driver substrate 3. In contrast, Figures 39 and 40 show an even further embodiment of the present invention, where a pair of image sensor chips 1 are mechanically coupled to each other by an interposed coupling layer 69. Thereafter, coupling lines 80 are formed across the coupling layer 69 to provide electrical connection between the corresponding sensing lines 5. The coupling line 80 may be formed by printing an electrically conductive paste, or by blowing such a paste onto a coupling surface by a jet nozzle. In this construction, mechanical and electrical connections between adjacent sensor chips are separated from each other to thereby simplify the device structure and to facilitate repairing of the coupling. This structure may supplement the other structure using the coupling chip.

As described above, in the inventive semiconductor device, the semiconductor chips and driver substrates are connected to each other by means which concurrently provide the electrical conduction and mechanical strength. Advantageously therefore a semiconductor device is provided of the high performance multiple chip mount type having a relatively simple structure which features good mechanical strength and reliability.

Embodiments of the present invention have been described with reference to the drawings and a person skilled in the art will appreciate that modifications may be made without departing from the scope of the present invention.

## Claims

1. A semiconductor device comprising:
a one or more semiconductor chips (1);
a semiconductor driving chip (2) for driving the or each semiconductor chip; characterised by combined mechanical and electrical means (4,7,14), said mechanical means for mechanically uniting either adjacent semiconductor chips with each other, or a semiconductor chip and a semiconductor driving chip; and
said electrical means for electrically connecting between the semiconductor chips and the semiconductor driving chip.

2. A semiconductor device according to claim 1; wherein the mechanical means and the electrical means constitutes a coupling chip (4,7,14).

3. A semiconductor device according to claim 2 wherein the coupling chip has formed thereon lead lines (8a,15a,53a) and junction electrodes (8,15).

4. A semiconductor device according to claim 3; including a driver substrate (3) for mounting the semiconductor driving chip, and wherein the driver substrate is connected to an adjacent semiconductor chip by the coupling chip.

5. A semiconductor device according to claim 4; wherein the driver substrate has formed thereon lead lines (23) and junction electrodes (20,21,22).

6. A semiconductor device according to claim 5; wherein the lead lines and junction electrodes of the coupling chip forms a pattern on a rear face thereof opposite to a front face of the semiconductor chip or the driver substrate.

7. A semiconductor device, as claimed in any one of claims 2 to 6, in which said coupling chip comprises a single crystal silicon plate.

8. A semiconductor device according to claim 7; wherein the coupling chip functions as the driving chip.

9. A semiconductor device according to any one of the claims 2 to 6; wherein the coupling chip comprises a glass plate.

10. A semiconductor device according to claim 9 when dependent on claim 3; wherein the glass plate has a protruded portion (50) formed on its surface such that the lead lines and the junction electrodes are formed on the remaining portion other than the protruded portion.

11. A semiconductor device as claimed in any one of claims 4 to 9 when dependent on claim 4, in which said driver substrate comprises a single crystal silicon plate.

12. A semiconductor device according to claim 11 but not when dependent on claim 8, wherein the driver substrate functions as the semiconductor driving chip.

13. A semiconductor device according to any one of claims 4 to 9 when dependent on claim 4, wherein the driver substrate comprises a glass plate.

14. A semiconductor device according to any one of claims 2 to 13, wherein the coupling chip has a mark pattern (9a,9b,11) formed on one face opposite to its active face.

15. A semiconductor device according to any of claims 2 to 14 wherein the semiconductor chip has integrated circuits formed on both faces of the chip and coupling chips are provided on both faces.

16. A semiconductor device according to any one of the preceding claims, further including a reinforcement member (60).

17. A semiconductor device according to any one of the preceding claims, further including a radiator plate (63).

18. A semiconductor device as claimed in any one of the preceding claims in which said semiconductor chips have formed thereon lead lines (5) and junction electrodes (6,27) and auxiliary electrodes (28).

19. A semiconductor device comprising: one or more semiconductor chips (1); a semiconductor driving chip (2) for driving the or each semiconductor chip; characterised by an interposed coupling layer (69) for mechanically coupling adjacent semiconductor chips or between a semiconductor chip and the semiconductor driving chip and by a plurality of coupling lines (80) for electrically coupling adjacent semiconductor chips or between a semiconductor chip and the semiconductor driving chip.

20. A semiconductor device as claimed in any one of the preceding claims, wherein the or each semiconductor chip is a semiconductor image sensor chip.

21. A method of producing a semiconductor device as claimed in claim 2, comprising aligning the or each semiconductor chip and the driver chip to set relative positions; and coupling adjacent pairs of the semiconductor chips with each other and coupling an adjacent pair of the semiconductor chip and the driver chip with each other by means of the coupling chip.

22. A method of producing a semiconductor device according to claim 21; wherein coupling by means of the coupling chips comprises applying an anisotropic electroconductive adhesive (40) to a coupling portion, and applying heat and pressure to the coupling portion.

23. A method of producing a semiconductor device according to claim 21; wherein coupling by means of the coupling chips comprises utilizing a coupling chip composed of glass for effecting coupling by anodic bonding.
